# EUROPEAN PATENT SPECIFICATION

(11) **EP 0 246 767 B1**
(45) Date of publication and mention of the grant of the patent: **12.01.1994**
(21) Application number: 87303753.5
(22) Date of filing: 28.04.1987
(51) Int. Cl.: G06F 5/06

(54) **Semiconductor memories**
Halbleiterspeicher
Mémoires à semi-conducteurs

(30) Priority: 28.04.1986 JP 98847/86; 30.04.1986 JP 100044/86
(43) Date of publication of application: 25.11.1987
(73) Proprietor: SONY CORPORATION, Tokyo 141 (JP)
(72) Inventor: Ebihara, Norio c/o Patents Division, Shinagawa-ku Tokyo 141 (JP); Sasaki, Takayuki c/o Patents Division, Shinagawa-ku Tokyo 141 (JP); Kita, Hiroyuki c/o Patents Division, Shinagawa-ku Tokyo 141 (JP); Ohsawa, Yoshihito c/o Patents Division, Shinagawa-ku Tokyo 141 (JP)
(74) Representative: Thomas, Christopher Hugo

(56) References cited:
- WESCON TECHNICAL PAPERS, vol. 16, 19th-22nd September 1972, pages 413.1 - 413.5, Western Electronic Show and Convention, Los Angeles, US; Y. HSIA: "Memory applications of the MNOS"
- IEEE JOURNAL OF SOLID-STATE CIRCUITS, vol. SC-19, no. 6, December 1984, pages 999-1007, IEEE, New York, US; R. PINKHAM et al.: "A high speed dual port memory with simultaneous serial and random mode access for video applications"
- PATENT ABSTRACTS OF JAPAN, vol. 7, no. 249 (P-234)[1394], 5th November 1983; & JP-A-58 133 698 (NIPPON DENKI K.K.) 09-08-1983
- SMPTE JOURNAL, vol. 89, no. 4, April 1980, pages 257-262, Scarsdale, US; T. YOSHINO et al.: "Digital frame memory for still picture television receivers PASS encoding system and application"

## Description

This invention relates to semiconductor memories. More particularly, but not exclusively, the invention relates to semiconductor asynchronous 3-port first-in-first-out (FIFO) memories. Such memories can be used, for example, in image processing in a video tape recorder or television receiver.

Asynchronous 3-port FIFO memories, which have serial-access memories (SAM) writing and reading out data, line by line, have been previously proposed. Such memories include first, second and third SAMs. The first SAM comprises a selector, a register, which may have, for example, a capacity of 1024 bits, and a first latch circuit. The second SAM comprises a second latch circuit and a first shift register. The third SAM comprises a third latch circuit and a second shift register.

Writing clock signals CKW are supplied for the selector, the register and the first latch circuit. Serial data are supplied to the register by way of an input terminal. When clear signals CLR0 are supplied for the selector, the data are cleared to be set to 0. The selector is actuated by means of write enable signals WE. Address signals are formed when clock signals CKW are supplied for the selector. The address signals are supplied to the register by the selector. Serial data from the input terminal are stored in the register at predetermined locations designated by the address signals, and the data stored in the register are temporarily latched in the first latch circuit.

The data latched by the first latch circuit are written, line by line, in a dynamic random-access memory (DRAM) at a predetermined location assigned by address signals produced from a writing address circuit.

The data written in the DRAM at a predetermined location assigned by address signals produced by a first read-out address circuit are read out, line by line, to be transferred to the second latch circuit to be further transferred to the first shift register. Read-out clock signals CKR1 are supplied for the first read-out address circuit, the second latch circuit and the first shift register. Clear signals CLR1 are also supplied for the first shift register.

The data transferred to the first shift register are shifted by 1bit whenever the clock signals CKL1 are supplied to a first outputterminal, to serve as first data.

On the other hand, the data written in the DRAM at a predetermined location assigned by address signals which are produced by a second read-out address circuit, are read out, line by line, to be transferred to the third latch circuit to be further transferred to the second shift register. Read-out clock signals CKL2 are supplied for the second address circuit, the third latch circuit and the second shift register. Clear signals CLR2 are also supplied for the second shift register.

The data transferred to the second shift register are shifted by 1bit whenever the clock signals CKL2 are supplied to a second output terminal to serve as second data.

A first port comprises the selector, the register and the first latch circuit. A second port comprises the second latch circuit and the first shift register. A third port comprises the third latch circuit and the second shift register. As mentioned above, the first, second and third ports can actuate asynchronously of each other.

However, with the above-mentioned device, there is the disadvantage that the chips forming the SAMs are of relatively large area, so the cost is high. In addition, the device does not have good operating efficiency.

WESCON TECHNICAL PAPERS, vol. 16, 19-22 September 1972, pages 4/3.1 to 4/3.5, Western Electronic Show and Convention, Los Angeles, US, Y.HSIA 'Memory applications of the MNOS' discloses a semiconductor memory having features corresponding to those of the preamble of claim 1.

According to the present invention there is provided storage means having a plurality of memory elements arranged in lines and formed with a plurality of blocks in each said line for storing data, each of said blocks being formed with a plurality of sequentially-numbered sub-blocks; and
input buffer means and output buffer means, each having at least a pair of memories for respectively inputting or receiving data relative to said storage means;
the memory capacity of said storage means being at least twice as large as, and a multiple of, the capacity of each of said memories in said input and output buffer means;
characterized by:
dividing means for dividing data into smaller data units and for simultaneously writing said smaller data units in parallel at the respective identically-numbered ones of said sub-blocks in all of said blocks in a respectively selected one of said lines; and
recombining means for recombining said smaller data units stored in said storage means at the respective identically-numbered ones of said sub-blocks in all of said blocks in a respectively selected one of said lines and for reading out recombined data.

The invention will now be described by way of example with reference to the accompanying drawings, throughout which like parts are referred to by like references, and in which:
Figure 1 is a block diagram of an embodiment of semiconductor memory according to the present invention;
Figure 2 is a diagram of a serial-access memory formed by an input buffer means in the memory of Figure 1;
Figure 3 is a diagram of a serial-access memory formed by an output buffer means in the memory of Figure 1;
Figure 4 is a block schematic diagram of input buffer means;
Figure 5 is a schematic diagram of the output buffer means;
Figure 6 is a block diagram of a dynamic random-access memory used in the memory of Figure1;
Figure 7 is a diagram showing the timing relationship between the dynamic random-access memory and the serial-access memory of the input buffer means;
Figure 8 is a diagram showing the timing relationship between the dynamic random-access memory and the serial-access memory of the output buffer means;
Figure 9 is a block diagram of another embodiment of semiconductor memory according to the present invention;
Figure 10 is a schematic wiring diagram of a switch and a selector in Figure 9;
Figure 11 is a detailed writing diagram of Figure 10; and
Figure 12 is a block diagram of a dynamic random-access memory used in the memory of Figure 9.

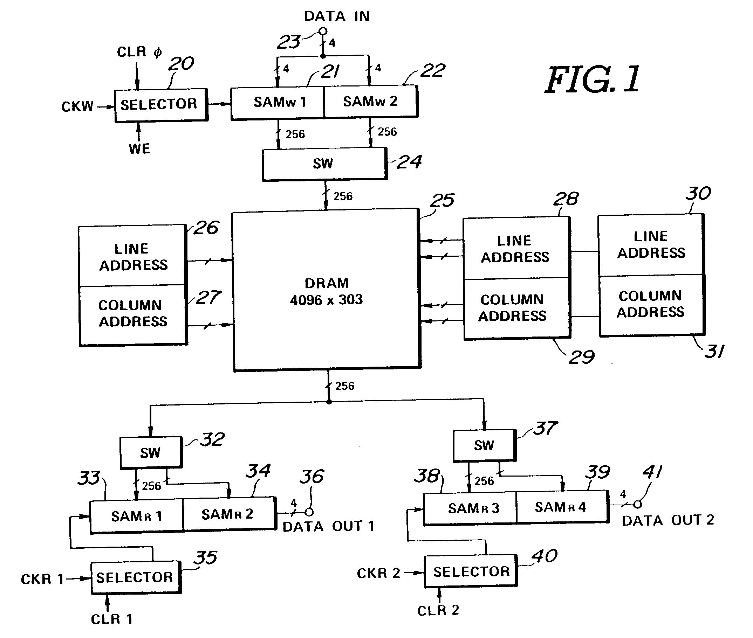

Referring now to the drawings, particularly to Figure 1, the preferred embodiment of semiconductor memory according to the present invention is an asynchronous 3-port FIFO field memory. The semiconductor memory includes a selector 20. When clear signals CLR 0 are supplied to the selector 20, the data are set to 0 to be cleared. The selector 20 is actuated by means of write enable signals WE. When clock signals CKW are supplied to the selector 20, address signals are formed. The selector 20 is connected to writing serial-access memories (SAMs) 21 and 22 of equal capacity. For example, the SAMs 21 and 22 may each have 256 bits of memory capacity. When data, in which a pixel is formed by 4 bits, are supplied to the SAMs 21 and 22 by way of an input terminal 23, the data are written in the SAMs 21 and 22 at a predetermined location designated by address signals. The SAMs 21 and 22 respectively have addresses numbered from 0 to 63 corresponding to 64 pixels, since they have 256 bits of memory capacity. Therefore, 4 bits of data supplied from the input terminal 23 are, in turn, written at the addresses designated by the address signals. The data written in the SAMs 21 and 22 are, in turn, picked up by means of a switch circuit 24 and supplied to a memory means, for example, a dynamic random-access memory (DRAM) 25. The data stored in the SAM 21 are transferred to the DRAM 25 while data are written in the SAM 22 and, conversely, the data stored in the SAM 22 are transferred to the DRAM 25 while data are written in the SAM 21. A first port comprises the selector 20, the SAMs 21 and 22, the input terminal 23 and the switch circuit 24.

The DRAM 25 may have, for example, 303 lines of capacity in which one line includes 4096 bits (4096 x 303). Each line may, for example, be divided into 16 blocks each having 256 bits. The DRAM 25 is connected to a writing line-address circuit 26 and a writing column address circuit 27. The line-address circuit 26 produced address signals to designate the line of the DRAM 25 in which the data are to be written. The column-address circuit 27 produces address signals to designate the column of the DRAM 25 in which the data are to be written. As a result, the 256 bits of data from the SAM 21 or 22 can be written in a predetermined block of the DRAM 25.

The DRAM 25 is also connected to a first read-out line-address circuit 28 and a first read-out column-address circuit 29. The line-address circuit 28 produces address signals to designate the line of the DRAM 25 from which the data are to be read out. The column-address circuit 29 produces address signals to designate the column of the DRAM 25 from which the data are to be read out. As a result, the 256 bits of data written in a predetermined block of the DRAM 25 can be read out.

The dram 25 is further connected to a second read-out line-address circuit 30 and a second read-out column-address circuit 31. The line-address circuit 30 produces address signals to designate the line of the DRAM 25 from which the data are to be read out. The column-address circuit 31 produces address signals to designate the column of the DRAM 25 from which the data are to be read out. As a result, the 256 bits of data written in a predetermined block of the DRAM 25 can be read out.

The output terminal of the DRAM 25 is connected to a switch circuit 32. The switch circuit 32 is also connected to SAMs 33 and 34 which each have the same capacity as that of the SAMs 21 and 22. The SAMs 33 and 34 are connected to a selector 35, which can operate in a similar manner to the selector 20, and an output terminal 36. A first output buffer means, which is a second port, comprises the SAMs 33 and 34, the selector 35 and the output terminal 36. The address circuits 28 and 29 produce address signals to designate 256 bits of data written in a predetermined block of the DRAM 25 to be read out. The 256 bits of data are selectively picked up by means of the switch circuit 32 and transferred to the SAM 33 or 34. The data written in the SAM 33 is read out while data supplied from the DRAM 25 is transferred to the SAM 34. Conversely, the data written in the SAM 34 is read out while data supplied from the DRAM 25 are transferred to the SAM 33. Data stored in the SAM 33 or 34 at a predetermined location designated by address signals, which are produced from the selector 35, are supplied to the output terminal 36, 4 bits at a time, that is, pixel by pixel.

The output terminal of the DRAM 25 is also connected to a switch circuit 37. The switch circuit 37 is also connected to SAMs 38 and 39 which each have the same capacity as that of the SAMs 21 and 22. The SAMs 38 and 39 are connected to a selector 40, which can operate in a similar manner to the selector 20, and an output terminal 41. A second output buffer means, which is a third port, comprises the SAMs 38 and 39, the selector 40 and the output terminal 41. The address circuits 30 and 31 produce address signals to designate 256 bits of data written in a predetermined block of the DRAM 25 to be read out. The 256 bits of data are selectively picked up by the switch circuit 32 and transferred to the SAM 38 or 39. The data written in the SAM 38 are read out, while data supplied from the DRAM 25 are transferred to the SAM 39. Conversely, the data written in the SAM 39 are read out while data supplied from the DRAM 25 are transferred to the SAM 38. Data stored in the SAM 38 or 39 at a predetermined location designated by address signals, which are produced from the selector 40, are supplied to the output terminal 41, 4 bits at a time, that is, pixel by pixel.

Preferably a toggle means is provided so that the data transfer from the SAM 21 or 22 to the DRAM 25 does not conflict with the data transfer from the DRAM 25 to the SAM 33, 34, 38 or 39. One of the data transfers is delayed relative to the other by the toggle means.

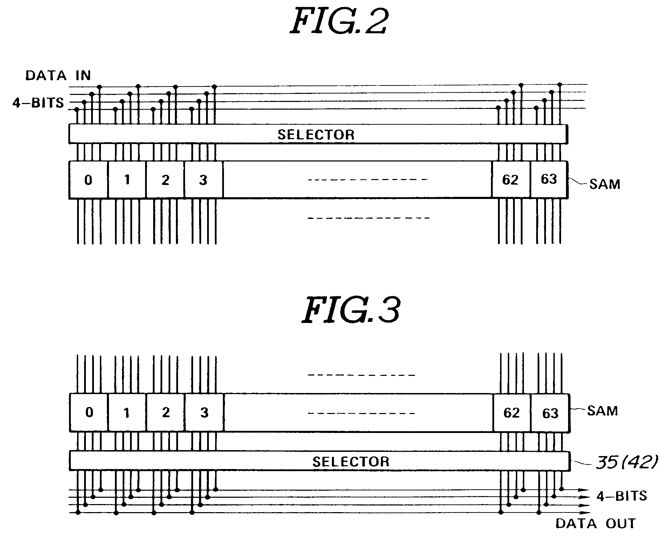

As shown in Figure 2, the input 4-bit data units can be selected by means of the selector 20 and written in the SAM 21 or 22, which form an input buffer means, at predetermined locations corresponding to the addresses numbered from 0 to 63.

As shown in Figure 3, each 4-bit data unit written in the SAM 33 or 34 at the addresses numbered from 0 to 63 can be selected by means of the selector 35 and supplied. Each 4-bit data unit written in the SAM 38 or 39 at the addresses numbered from 0 to 63 can also be selected by means of the selector 40 and supplied.

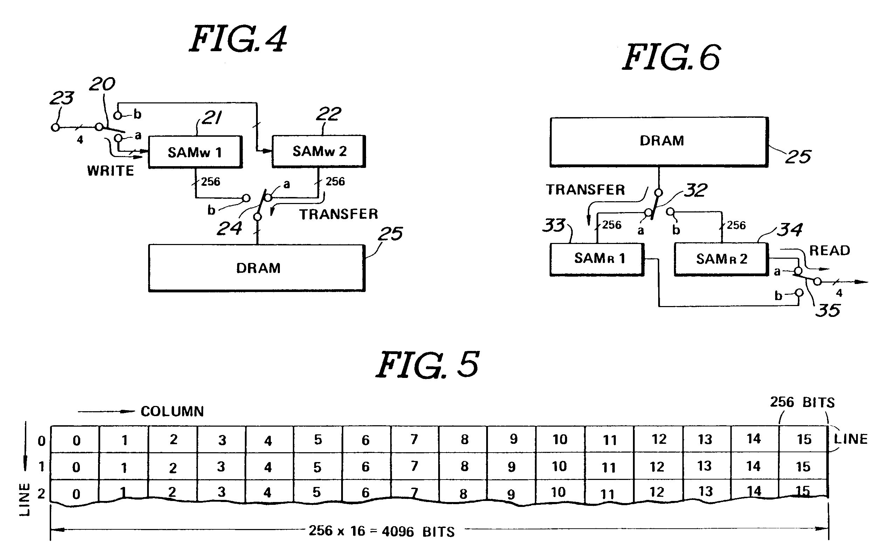

Figure 4 shows the input buffer means for transferring data from the SAM 21 or 22 to the DRAM 25. In Figure 4, the selector 20 is shown as a single-pole double-throw switch for reasons of convenience. The selector 20 is associated with the switch circuit 24. The switch circuit 24 engages its contact a when the selector 20 engages its contact a. Conversely, the switch contact 24 engages its contact b when the selector 20 engages its contact b. Therefore, when both the selector 20 and the switch circuit 24 engage their contacts a, each of 4-bit data units from the input terminal 23 are, in turn, written in the SAM 21 and simultaneously the 256-bits data written in the SAM 22 are transferred to the DRAM 25. Conversely, when both the selector 20 and the switch circuit 24 engage their contacts b, each of 4 bits of data from the input terminal 23 are, in turn, written in the SAM 22 and simultaneously the 256-bits data written in the SAM 21 are transferred to the DRAM 25.

As shown in Figure 5, the DRAM 25 may include 303 lines arranged vertically, each of which may be divided into 16 blocks numbered from 0 to 15. One block may have 256 bits of capacity and one line may have 4096 bits (256 x 16) of capacity. Therefore, there is a map comprising 16 columns x 303 lines.

As mentioned above, each of 256-bits data transferred from the SAMs 21 and 22 are, in turn, written in a predetermined block, the line and column of which are assigned by the address circuits 26 and 27, respectively, shown in Figure 1.

Figure 6 shows the first output buffer means for transferring data from the DRAM 25 to the SAM 33 or 34. In Figure 6, the selector 35 is shown as a single-pole double-throw switch for reasons of convenience. The switch circuit 32 is associated with the selector 35. The switch circuit 32 engages its contact a when the selector 35 engages its contact a. Conversely, the switch circuit 32 engages its contact b when the selector 20 engages its contact b. Therefore, when both the selector 35 and the switch circuit 32 engage their contact a, the 256 bits of data written in the DRAM 25 at a predetermined block, the line and column of which have been determined by the address circuits 28 and 29 shown in Figure 1, are transferred to the SAM 33 and simultaneously 256 bits of data written in the SAM 34 are, in turn, supplied 4 bits at a time. On the contrary, when both the selector 35 and the switch circuit 32 engage their contact b, the 256 bits data written in the DRAM 25 at a predetermined block, the line and column of which have been determined by the address circuits 28 and 29, are transferred to the SAM 34, and simultaneously the 256 bits of data written in the SAM 33 are, in turn, supplied 4 bits at a time.

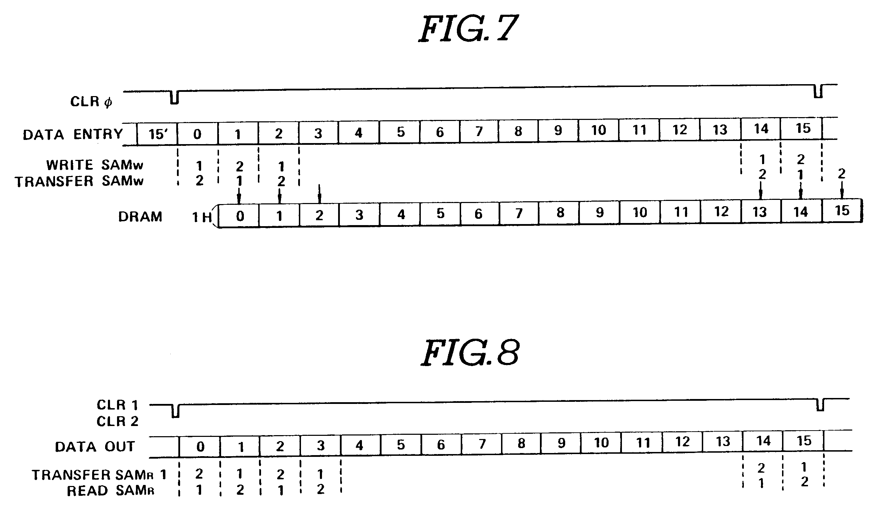

Figure 7 shows the timing relationship between the DRAM 25 and the SAMs 21 and 22 which from the input buffer means. When clear signals CLR 0 are supplied to the selector 20, the 256 bits of data to be written in the DRAM 25 at the block 0 are written in the SAM 1 serving as a writing SAM, for example, the SAM 21, and simultaneously the 256 bits of data written in the SAM 2 serving as a transferring SAM, for example the SAM 22, are transferred to the block 15 of the DRAM 25. Secondly, the 256 bits of data to be written in the DRAM 25 at the block 1 are written in the SAM 2 serving as the writing SAM and simultaneously the 256 bits data written in the SAM 1 serving as the transferring SAM are transferred to the block 0 of the DRAM 25. Next, the 256 bits of data to be written in the DRAM 25 at the block 2 are written in the SAM 1 serving as the writing SAM and simultaneously the 256 bits data written in the SAM 2 serving as the transferring SAM are transferred to the block 1 of the DRAM 25. Data written in one SAM are transferred to the DRAM 25 while data are written in the other SAM. This operation is repeated until the transfer of all of the data has been finished.

Figure 8 shows the timing relationship between the DRAM 25 and the SAMs 33 and 34 or 38 and 39 which form the output buffer means. When clear signals CLR 1 or 2 are applied to the selector 35 or 40, the 256 bits of data corresponding to the data stored in the block 0 of the DRAM 25, which are written in the SAM 1 serving as a read-out SAM, for example the SAM 33 or 38 , is supplied at a time, and simultaneously the 256 bits of data stored in the block 1 of the DRAM 25 are transferred to the SAM 2 serving as a transferring SAM, for example, the SAM 34 or 39. Secondly, the 256 bits of data corresponding to the data stored in the block 1 of the DRAM 25, which are written in the SAM 2 serving as the read-out SAM, are supplied 4 bits at a time, and simultaneously the 256 bits of data stored in the block 2 of the DRAM 25 are transferred to the SAM 1 serving as the transferring SAM. Next, the 256 bits of data corresponding to the data stored in the block 2 of the DRAM 25, which are written in the SAM 1 serving as the read-out SAM, are supplied 4 bits at a time and simultaneously the 256 bits of data stored in the block 3 of the DRAM 25 are transferred to the SAM 2 serving as the transferring SAM. Data are transferred from the DRAM 25 to one SAM while data written in the other SAM are supplied. This operation is repeated until all of the data have been read out.

With this embodiment, the SAM having 256 bits of capacity, which is a sixteenth part of 4096 bits corresponding to the memory capacity per line, is used, but other types of SAM having a capacity which is a fraction, such as an eighth or fourth part thereof, can also be used.

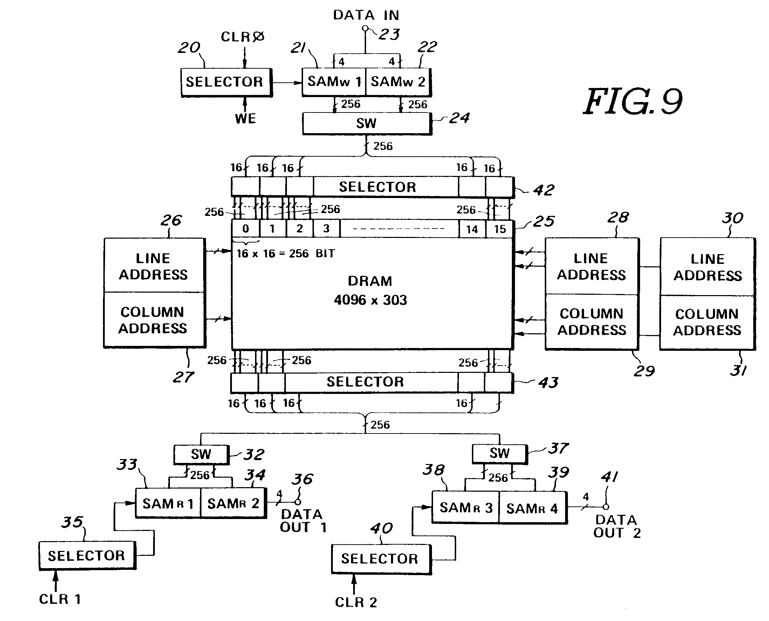

Figure 9 shows another embodiment of semiconductor memory according to the present invention. In this embodiment, a selector 42 is provided between the switch circuit 24 and the DRAM 25. The selector 42 is divided into 16 blocks corresponding to the blocks 0 to 15 of the DRAM 25. The 256-bit data lines are divided by means of the switch circuit 24 into sixteen 16-bit data lines and introducing into each block of the selector 42 corresponding to the block 0 to 15 of the DRAM 25. A selector 43 is also provided between the DRAM 25 and the switch circuit 32 and 37. The selector 43 is also divided into 16 blocks corresponding to the blocks 0 to 15 of the DRAM 25. Each 16-bit data line is introduced through the DRAM 25 into each block of the selector 43 corresponding to the block 0 to 15 of the DRAM 25. All 16-bit data lines from the selector 43 are gathered together to make 256-bit data lines which are introduced into the switch circuits 32 and 37. The selector 42 is controlled by means of address signals produced by the column-address circuit 27. The selector 43 is controlled by means of address signals produced by the column-address circuits 29 and 31.

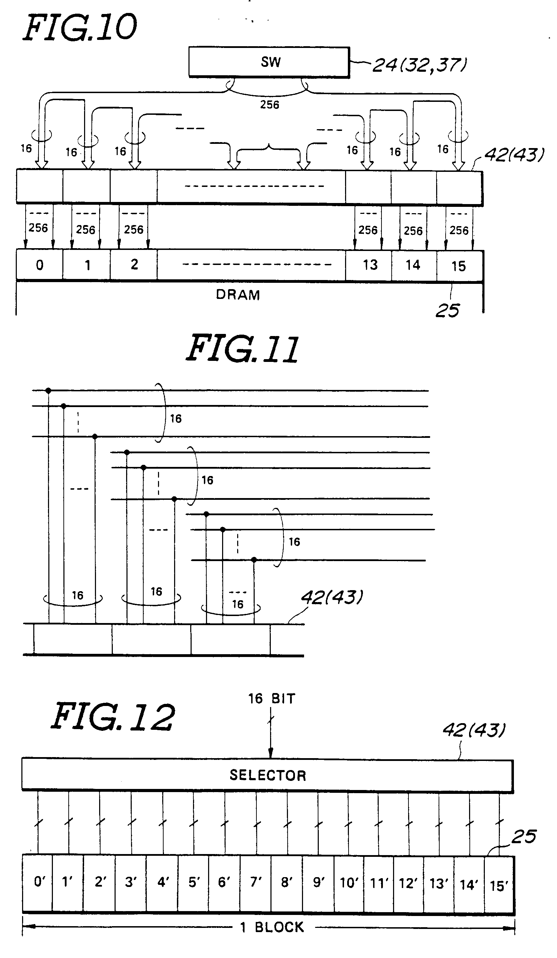

As shown in detail in Figure 10, the 256-bit data lines are divided by means of the switch circuits 24, 32 or 37 into, for example, two 128-bit data lines horizontally extending from near the centre of the switch circuit 24, 32 or 37 towards the left and right sides, respectively. The left-hand 128-bit data lines are introduced into the blocks of the selector 42 or 43 corresponding to the blocks 0 to 7 of the DRAM 25. The right-hand 128-bit data lines are introduced into the blocks of the selector 42 or 43 corresponding to the blocks 8 to 15 of the DRAM 25. As shown in detail in Figure 11, each 16-bit data line selected from the 128-bit data lines extends vertically to be introduced into each block of the selector 42 or 43.

In this embodiment, each of the 16 blocks numbered 0 to 15 of the DRAM 25 is divided into 16 sub-blocks numbered 0ʹ to 15ʹ as shown in Figure 12. The 16 bits of data are written in each of the sub-blocks by means of a block of the selector 42. On the other hand, each 16 bits of data written in each of the sub-blocks are read out by means of a block of the selector 43.

For example, in order to transfer the 256 bits of data stored in the SAM 21 to the DRAM 25, the 256 bits of data obtained at the output terminal of the switch circuit 24 are divided into 16-bit units and each of these 16-bit data units are, in turn, transferred to one of the even sub-blocks, that is, the sub-blocks 0ʹ, 2ʹ, 4ʹ, 6ʹ, 8ʹ, 10ʹ, 12ʹ and 14ʹ disposed in one of the blocks 0 to 15 of the DRAM 25, by means of each of the blocks of the selector 42. On the other hand, in order to transfer the 256 bits of data stored in the SAM 22 to the DRAM 25, the 256 bits of data obtained at the output terminal of the switch circuit 24 are divided into sixteen 16-bit data units and each of these 16-bit data units are, in turn, transferred to one of the odd sub-blocks, that is, the sub-blocks, 1ʹ, 3ʹ, 5ʹ, 7ʹ, 9ʹ, 11ʹ, 13ʹ and 15ʹ disposed in one of the blocks 0 to 15 of the DRAM 25 by means of each of the blocks of the selector 42.

That is, all the 256 bits of data stored in the SAM 21, 16 bits at a time, are simultaneously transferred to the sub-blocks 0ʹ of the blocks 0 to 15 of the DRAM 25 by means of the blocks of the selector 42. Secondly, all 256 bits of data stored in the SAM 22, 16 bits by 16 bits, are simultaneously transferred to the sub-blocks, 1ʹ of the blocks 0 to 15 of the DRAM 25 by means of the blocks of the selector 42. This operation is repeated.

Conversely, in order to transfer the data written in the DRAM 25 to the SAMs 33 and 34, all 16 bits of data written in the even sub-blocks of the blocks 0 to 15 of the DRAM 25 are simultaneously read out by means of the blocks of the selector 43 to be 256 bits (16 x 16) of data to be transferred to the SAM 33 through the switch circuit 32.

That is, all of the 16-bit data units written in the sub-blocks 0ʹ of the blocks 0 to 15 of the DRAM 25 are simultaneously read out by means of the blocks of the selector 43 to make up 256 bits of data to be transferred to the SAM 33 through the switch 32. Secondly, all of the 16-bit data units written in the sub-blocks 1ʹ of the blocks 0 to 15 of the DRAM 25 are simultaneously read out by means of the blocks of the selector 43 to be 256 bits of data so as to be transferred to the SAM 34. This operation is repeated.

When the data written in the DRAM 25 are transferred to the SAMs 38 and 39, such an operation is carried out.

As described above, the 256 bits of data, which are alternately transferred from the SAMs 21 and 22 to the output terminal of the switch circuit 24, are divided into sixteen 16-bit data units and all of the 16-bit data units are simultaneously transferred to the like numbered sub-blocks of the blocks 0 to 15 of the DRAM 25. All of the 16-bits data units written in the like numbered sub-blocks of the blocks 0 to 15 of the DRAM 25 are simultaneously read out to make up 256 bits of data to be transferred to the SAMs 33 and 34 or the SAMs 38 and 39. Therefore, the wiring area between the switch circuit 24 and the selector 42 and between the selector 43 and the switch circuits 32 and 37 can be small.

The above description refers to SAMs having 256 bits of memory capacity, and a DRAM having 16 horizontal blocks, but other types of SAM and DRAM can be used.

## Claims

1. A semiconductor memory comprising:
storage means (25) having a plurality of memory elements arranged in lines and formed with a plurality of blocks in each said line for storing data, each of said blocks being formed with a plurality of sequentially-numbered sub-blocks; and
input buffer means (20 to 22) and output buffer means (33 to 35, 38 to 40), each having at least a pair of memories for respectively inputting or receiving data relative to said storage means;
the memory capacity of said storage means (25) being at least twice as large as, and a multiple of, the capacity of each of said memories in said input and output buffer means (20 to 22; 33 to 35, 38 to 40);
characterized by:
dividing means (24, 42) for dividing data into smaller data units and for simultaneously writing said smaller data units in parallel at the respective identically-numbered ones of said sub-blocks in all of said blocks in a respectively selected one of said lines; and
recombining means (43, 32, 33, 34; 43, 37, 38, 39) for recombining said smaller data units stored in said storage means (25) at the respective identically-numbered ones of said sub-blocks in all of said blocks in a respectively selected one of said lines and for reading out recombined data.

2. A memory according to claim 1 connected to first and second address-designating means (26 to 31) for producing address signals for designating the location in said storage means (25) to and from which said data are transferred, respectively.

3. A memory according to claim 2 wherein said input buffer means (20 to 22) comprises first and second memory means (21, 22), and further comprising a first switching means (24) for transferring data stored in said first memory means (21) to said storage means (25) while data are written in said second memory means (22), and for transferring data stored in said second memory means (22) to said storage means (25) while data are written in said first memory means (21).

4. A memory according to claim 2 wherein said output buffer means (33 to 35, 38 to 40) comprises third and fourth memory means (33, 34, 38, 39), and further comprising a second switching means (32, 37) for reading out data written in said third memory means (33, 34) while data supplied from said storage means (25) are transferred to said fourth memory means (38, 39), and for reading out data written in said fourth memory means (38, 39) while data supplied from said storage means (25) are transferred to said third memory means (32, 34).

5. A memory according to any one of the preceding claims wherein said input and output buffer means (20 to 22, 33 to 35, 38 to 40) comprise a plurality of serial-access memories (21, 22; 33, 34; 38, 39).

6. A memory according to any one of the preceding claims wherein said storage means (25) comprises a dynamic random-access memory (25).

7. A memory according to any one of the preceding claims which is connected to a toggle means for delaying one transfer relative to the other between the transfer of data from said input buffer means (20 to 22) to said storage means (25) and the transfer of data from said storage means (25) to said output buffer means (33 to 41) so as not to conflict with each other.

8. A memory according to any one of the preceding claims wherein said dividing and recombining means (20; 35, 40) include a selector (20; 35, 40) having a plurality of blocks corresponding to said blocks of said storage means (25).

## Patentansprüche

1. Halbleiterspeicher
mit einer Speichereinrichtung (25) mit einer Mehrzahl von Speicherelementen, die in Zeilen angeordnet und in jeder Zeile eine Mehrzahl von Blöcken zur Speicherung von Daten bilden, wobei jeder dieser Blöcke eine Mehrzahl von fortlaufend numerierten Unterblöcken bildet,
sowie mit Eingangspuffereinrichtungen (20 bis 22) und Ausgangspuffereinrichtungen (33 bis 35, 38 bis 40) mit jeweils einem Paar von Speichern zur Eingabe bzw. zum Empfang von Daten in die bzw. aus der Speichereinrichtung,
wobei die Speicherkapazität der Speichereinrichtung (25) wenigstens doppelt so groß ist wie die Speicherkapazität der genannten Speicher in den Eingangs- und Ausgangspuffereinrichtungen (20 bis 22; 33 bis 35, 38 bis 40),
**gekennzeichnet durch**
eine Teilereinrichtung (24, 42) zum Teilen von Daten in kleinere Dateneinheiten und zum gleichzeitigen parallelen Einschreiben der kleineren Dateneinheiten an den jeweils gleich numerierten Exemplaren der Unterblöcke in allen Blöcken in einem entsprechenden ausgewählten Exemplar der genannten Zeilen und
eine Rekombinationseinrichtung (43, 32, 33, 34; 43, 37, 38, 39) zum Rekombinieren der in der Speichereinrichtung (25) an den betreffenden gleich numerierten Exemplaren der Unterblöcke in allen Blöcken in einem ausgewählten Exemplar der genannten Zeile gespeicherten kleineren Dateneinheiten und zum Auslesen der rekombinierten Daten.

2. Speicher nach Anspruch 1, verbunden mit einer ersten und einer zweiten Adressenbestimmungseinrichtung (26 bis 31) zur Erzeugung von Adressensignalen zur Bestimmung der Stelle in der Speichereinrichtung (25), zu der bzw. von der Daten übertragen werden.

3. Speicher nach Anspruch 2, bei dem die Eingangspuffereinrichtungen (20 bis 22) erste und zweite Speichermittel (21, 22) aufweisen und bei dem weiterhin ein erstes Schaltmittel (24) vorgesehen ist zum Übertragen von in dem ersten Speichermittel (21) gespeicherten Daten in die Speichereinrichtung (25), während Daten in das zweite Speichermittel (22) eingeschrieben werden, und zum Übertragen von in dem zweiten Speichermittel (22) gespeicherten Daten in die Speichereinrichtung (25), während Daten in das erste Speichermittel (22) eingeschrieben werden.

4. Speicher nach Anspruch 2, bei dem die Ausgangspuffereinrichtungen (33 bis 35, 38 bis 40) dritte und vierte Speichermittel (33, 34, 38, 39) aufweisen und bei dem weiterhin ein zweites Schaltmittel (32, 37) vorgesehen ist zum Auslesen von in dem dritten Speichermittel (33, 34) eingeschriebenen Daten, während aus der Speichereinrichtung (25) gelieferte Daten zu dem vierten Speichermittel (38, 39) übertragen werden, und zum Auslesen von in dem vierten Speichermittel (38, 39) eingeschriebenen Daten, während aus der Speichereinrichtung (25) gelieferte Daten zu dem dritten Speichermittel (32, 34) übertragen werden.

5. Speicher nach einem der vorhergehenden Ansprüche, bei dem die Eingangs- und Ausgangspuffereinrichtungen (20 bis 22; 33 bis 35, 38 bis 40) eine Mehrzahl von Speichern (21, 22; 33, 34; 38, 39) mit seriellem Zugriff umfassen.

6. Speicher nach einem der vorhergehenden Ansprüche, bei dem die Speichereinrichtung (25) einen dynamischen Speicher (25) mit wahlfreiem Zugriff umfaßt.

7. Speicher nach einem der vorhergehenden Ansprüche, verbunden mit einer bistabilen Kippeinrichtung, mittels derer bei der Übertragung von Daten aus den Eingangspuffereinrichtungen (20 bis 22) zu der Speichereinrichtung (25) und der Übertragung von Daten aus der Speichereinrichtung (25) zu den Ausgangspuffereinrichtungen (33 bis 35, 38 bis 40) eine dieser Übertragungen relativ zu der anderen Übertragung verzögerbar ist, damit die Übertragungen nicht miteinander in Konflikt kommen.

8. Speicher nach einem der vorhergehenden Ansprüche, bei der die Teiler- und Rekombinationseinrichtung (20; 35, 40) einen Wähler (20; 35, 40) umfaßt mit einer Mehrzahl von Blöcken, die den Blöcken der Speichereinrichtung (25) entsprechen.

## Revendications

1. Mémoire à semiconducteur comprenant :
un moyen de stockage (25) comprenant une pluralité d'éléments de mémoire agencés selon des lignes et constitué par une pluralité de blocs dans chaque dite ligne pour stocker des données, chacun desdits blocs étant constitué par une pluralité de sous-blocs numérotés séquentiellement ;
un moyen de tampon d'entrée (20 à 22) et un moyen de tampon de sortie (33 à 35, 38 à 40), chacun comportant au moins une paire de mémoires pour respectivement entrer ou recevoir des données en relation avec ledit moyen de stockage ; et
la capacité mémoire dudit moyen de stockage (25) valant au moins deux fois la capacité de chacune desdites mémoires contenues dans lesdits moyens de tampon d'entrée et de sortie (20 à 22 ; 33 à 35, 38 à 40) et étant un multiple de celle-ci,
caractérisée par :
un moyen de division (24, 42) pour diviser des données en unités de données plus petites et pour simultanément écrire lesdites unités de données plus petites en parallèle au niveau desdits sous-blocs respectifs numérotés à l'identique contenus dans tous lesdits blocs de l'une respectivement sélectionnée desdites lignes ; et
un moyen de recombinaison (43, 32, 33, 34 ; 43, 37, 38, 39) pour recombiner lesdites unités de données plus petites stockées dans ledit moyen de stockage (25) au niveau desdits sous-blocs respectifs numérotés à l'identique contenus dans tous lesdits blocs de l'une respectivement sélectionnée desdites lignes et pour lire les données recombinées.

2. Mémoire selon la revendication 1, connectée à des premier et second moyens de désignation d'adresse (26 à 31) pour produire des signaux d'adresse pour désigner l'emplacement dans ledit moyen de stockage (25) vers et depuis lequel lesdites données sont respectivement transférées.

3. Mémoire selon la revendication 2, dans laquelle ledit moyen de tampon d'entrée (20 à 22) comprend des premier et second moyens de mémoire (21, 22), et comprenant en outre un premier moyen de commutation (24) pour transférer des données stockées dans ledit premier moyen de mémoire (21) jusqu'audit moyen de stockage (25) tandis que des données sont écrites dans ledit second moyen de mémoire (22), et pour transférer des données stockées dans ledit second moyen de mémoire (22) jusqu'audit moyen de stockage (25) tandis que des données sont écrites dans ledit premier moyen de mémoire (21).

4. Mémoire selon la revendication 2, dans laquelle ledit moyen de tampon de sortie (33 à 35, 38 à 40) comprend des troisième et quatrième moyens de mémoire (33, 34, 38, 39), et comprenant en outre un second moyen de commutation (32, 37) pour lire des données écrites dans ledit troisième moyen de mémoire (33, 34) tandis que des données appliquées depuis ledit moyen de stockage (25) sont transférées jusqu'audit quatrième moyen de mémoire (38, 39), et pour lire des données écrites dans ledit quatrième moyen de mémoire (38, 39) tandis que des données appliquées depuis ledit moyen de stockage (25) sont transférées jusqu'audit troisième moyen de mémoire (32, 34).

5. Mémoire selon l'une quelconque des revendications précédentes, dans laquelle lesdits moyens de tampon d'entrée et de sortie (20 à 22, 33 à 35, 38 à 40) comprennent une pluralité de mémoires à accès série (21, 22 ; 33, 34 ; 38, 39).

6. Mémoire selon l'une quelconque des de stockage (25) comprend une mémoire vive dynamique (25).

7. Mémoire selon l'une quelconque des revendications précédentes, laquelle est connectée à un moyen de basculement pour retarder un transfert par rapport à l'autre entre le transfert de données depuis ledit moyen de tampon d'entrée (20 à 22) jusqu'audit moyen de stockage (25) et le transfert de données depuis ledit moyen de stockage (25) jusqu'audit moyen de tampon de sortie (33 à 41) de manière à faire en sorte qu'ils ne soient pas en conflit l'un avec l'autre.

8. Mémoire selon l'une quelconque des revendications précédentes, dans laquelle lesdits moyens de division et de recombinaison (20 ; 35, 40) incluent un sélecteur (20 ; 35, 40) comportant une pluralité de blocs correspondant auxdits blocs dudit moyen de stockage (25).
